# EUROPEAN PATENT APPLICATION

(11) **EP 4 661 279 A1**
(43) Date of publication of application: **10.12.2025**
(21) Application number: 25179482.2
(22) Date of filing: 28.05.2025
(51) Int. Cl.: H02M 7/521, H02M 7/5387, G01R 31/42

(54) **MONITORING HEALTH OF A POWER CONVERTER**

(30) Priority: 05.06.2024 GB 202407961
(71) Applicant: Rolls-Royce Deutschland Ltd & Co KG, 15827 Blankenfelde-Mahlow (DE)
(72) Inventor: VAIYAPURI, Viswanathan, 15827 Blankenfelde-Mahlow (DE); NADARAJAN, Sivakumar, 15827 Blankenfelde-Mahlow (DE); MOHAMED HALICK, Mohamed Sathik, 15827 Blankenfelde-Mahlow (DE)

(57) **Abstract**

A method (100) for monitoring a health of a power converter (201) having a plurality of power devices (202) comprises: selecting a first power device and a second power device from the plurality of power devices (202); injecting simultaneously a control pulse (CP) to only the first power device and the second power device; determining first voltage and current slew rates of the first power device and second voltage and current slew rates of the second power device; determining a voltage slew rate ratio of the first voltage slew rate to the second voltage slew rate; determining a current slew rate ratio of the first current slew rate to the second current slew rate; determining that the power converter (201) is degraded if the voltage and current slew rate ratios lie outside respective predetermined voltage and current slew rate ratio ranges.

## Description

### FIELD

The present invention relates to a method for monitoring a health of a power converter.

### BACKGROUND

Electrical devices, such as, power converters are used in a multitude of applications where an efficient management and transformation of electrical energy is required. The power converters may be employed where an alternating current is the primary mode of power delivery, such as in renewable energy integration, vehicular propulsion, and various industrial processes. Despite their role, the power converters may also be susceptible to operational disruptions due to component degradation, which can lead to significant downtime and maintenance costs. The degradation often stems from thermal and electrical stress, particularly affecting the components that are responsible for maintaining system performance and longevity.

Traditional methods for detecting failures in components of the power converters often involve continuous monitoring with high sampling rates and the use of complex algorithms processed by advanced processors. These stipulations can lead to increased costs, complexity, and potential interference with the power converters. Furthermore, existing solutions might not be easily transportable, which can limit their effectiveness during routine checks, service, or maintenance activities.

There is a recognized requirement for a more efficient approach to monitor the health of the power converter. Such approach would ideally reduce the demand for continuous data collection and complex processing, while still effectively identifying early signs of wear and potential failures of the power converter.

### SUMMARY

In accordance with a first aspect of the present disclosure, a method for monitoring a health of a power converter having a plurality of power devices is disclosed. The method comprises electrically connecting the power converter to a DC voltage supply and a load. The method further comprises selecting a first power device and a second power device from the plurality of power devices. The method further comprises injecting simultaneously a control pulse to only the first power device and the second power device for a predetermined time duration. The method further comprises determining a first voltage slew rate of the first power device and a second voltage slew rate of the second power device. The method further comprises determining a first current slew rate of the first power device and a second current slew rate of the second power device. The method further comprises determining a voltage slew rate ratio of the first voltage slew rate to the second voltage slew rate. The method further comprises determining a current slew rate ratio of the first current slew rate to the second current slew rate. The method further comprises determining that the power converter is degraded if at least one: the voltage slew rate ratio lies outside a predetermined voltage slew rate ratio range; and the current slew rate ratio lies outside a predetermined current slew rate ratio range.

The method of the present disclosure may not interfere with an operation of the power converter. Instead, the method may be performed before a prestart check or during a service or an on-wing inspection/maintenance to monitor the health of the power converter, such as identifying early device aging and failure and thereby predicting component degradation. This may increase availability and improve reliability of the power converter.

The method may further eliminate a need of an equipment health monitoring (EHM) unit on an aircraft, which may reduce a certification demand and a weight of the aircraft. The method may allow maintenance to be scheduled in or other actions to be taken to prevent consequential damages of a power and propulsion system of the aircraft.

The method may not require continuous voltage and current measurement with a high sampling rate. Further, the method may use less amount of data with respect to other conventional condition monitoring approaches to monitor the health of the power converter, such as identifying early device aging and failure. Therefore, the method may be easy to implement. Further, the method may not require a high-end processor. Instead, the method may be executed by a less complex processing unit for monitoring the health of the power converter. Further, the method may be applicable to any type of power converters (e.g., low power converters and high-power converters) having any type of power devices.

Further developments of the invention can be found in the dependent claims and show particularly advantageous possibilities to realize above-described concept in light of the object of the disclosure and regarding further advantages.

In some embodiments, determining the first voltage slew rate of the first power device comprises measuring a first voltage across the first power device using a first voltage sensor and determining the first voltage slew rate as a rate of change of the first voltage with respect to time.

In some embodiments, determining the second voltage slew rate of the second power device comprises measuring a second voltage across the second power device using a second voltage sensor and determining the second voltage slew rate as a rate of change of the second voltage with respect to time.

The first and second voltage slew rates may provide valuable diagnostic information that may be used to detect early signs of degradation or impending failure.

In some embodiments, determining the first current slew rate of the first power device comprises measuring a first current through the first power device using a first current sensor and determining the first current slew rate as a rate of change of the first current with respect to time.

In some embodiments, the first current sensor is a Rogowski coil.

In some embodiments, determining the second current slew rate of the second power device comprises measuring a second current through the second power device using a second current sensor and determining the second current slew rate as a rate of change of the second current with respect to time.

In some embodiments, the second current sensor is a Rogowski coil.

The first and second current slew rates may provide valuable diagnostic information that may be used to detect early signs of degradation or impending failure. Further, use of the Rogowski coils as the first and second current sensors may enable non-intrusive current measurements without requiring a direct electrical connection to circuitry of the power converter. The Rogowski coil may further eliminate the need for any high voltage isolation and reduce complexity and potential safety risks associated with measurement procedure. Further, the Rogowski coil may have an ability to measure rapidly changing currents accurately. The Rogowski coil may further enhance the practicality and efficiency of the method for monitoring the health of the power converter due to its ease of installation around a conductor.

In some embodiments, the control pulse is simultaneously provided to only the first power device and the second power device by a controller of the power converter.

Therefore, the method may use less amount of data with respect to other conventional condition monitoring approaches to monitor the health of the power converter.

In some embodiments, the voltage slew rate ratio and the current slew rate ratio are determined by using a portable health monitoring unit.

The portable health monitoring unit may enable on-site and immediate assessment of the health of the power converter before the prestart check or during the service or the on-wing inspection/maintenance. Furthermore, the portable health monitoring unit may be easily transportable, which may be provide effectiveness during routine checks, service, or maintenance activities.

In some embodiments the portable health monitoring unit is used for determining if the power converter is degraded.

Utilizing the portable health monitoring unit to determine if the power converter is degraded may allow for timely and efficient identification of degradation of the health of the power converter.

In some embodiments, the control pulse has a frequency range from 1 Hertz (Hz) to 1 Megahertz (MHz).

Therefore, the method may not require continuous voltage and current measurement with a high sampling rate.

In some embodiments, the predetermined time duration is based on a duty cycle of the control pulse.

The predetermined time duration based on a duty cycle of the control pulse may ensure accurate measurements of the first and second voltage slew rates and the first and second current slew rates.

In some embodiments, the predetermined voltage slew rate ratio range and the predetermined current slew rate ratio range are based on historical data.

This historical data-driven approach may allow for more accurate and reliable identification of deviations over time that may determine degradation or failure of the power converter, leading to improved diagnostic precision.

In some embodiments, the method comprises providing an alert upon determining that the power converter is degraded.

The alert may allow timely intervention, which could prevent damage to the power converter and/or downstream components. It may also facilitate the scheduling of maintenance or repairs, potentially avoiding unplanned downtime. This may increase availability and improve reliability of the power converter.

In some embodiments, the DC voltage supply is a battery. The battery may include any battery based on desired application attributes.

It shall be understood that the method according to the first aspect of the disclosure may comprise identical or similar developments, in particular as described in the dependent claims. Therefore, a development of one aspect of the disclosure is also applicable to another aspect of the disclosure.

These and other aspects of the invention will be apparent from and elucidated with reference to the embodiments described hereinafter. The embodiments of the invention are described in the following on the basis of the drawings. The latter is not necessarily intended to represent the embodiments to scale. Drawings are, where useful for explanation, shown in schematized and/or slightly distorted form. With regard to additions to the teachings immediately recognizable from the drawings, reference is made to the relevant state-of-the-art. It should be borne in mind that numerous modifications and changes can be made to the form and detail of an embodiment without deviating from the general idea of the disclosure.

In addition, all combinations of at least two of the features disclosed in the description, drawings and/or claims fall within the scope of the disclosure. The general idea of the disclosure is not limited to the exact form or detail of the preferred embodiment shown and described below, or to an object which would be limited in comparison to the object claimed in the claims. For specified design ranges, values within the specified limits are also disclosed as limit values and thus arbitrarily applicable and claimable.

### BRIEF DESCRIPTION OF THE DRAWINGS

Further advantages, features and details of the invention result from the following description of the preferred embodiments as well as from the drawings, which show in:
FIG. 1 is a schematic block diagram of a power converter health monitoring system, according to an embodiment of the present disclosure;
FIG. 2 is a schematic block diagram of the power converter health monitoring system and a plurality of voltage sensors, according to an embodiment of the present disclosure;
FIG. 3 is a schematic block diagram of the power converter health monitoring system and a plurality of current sensors, according to an embodiment of the present disclosure;
FIG. 4 is a schematic block diagram of a current sensor from the plurality of current sensors, according to an embodiment of the disclosure;
FIG. 5 is a schematic block diagram of the power converter health monitoring system, according to an embodiment of the present disclosure; and
FIG. 6 is a flow chart of a method for monitoring a health of a power converter, according to an embodiment of the present disclosure.

### DETAILED DESCRIPTION

Aspects and embodiments of the present disclosure will now be discussed with reference to the accompanying figures. Further aspects and embodiments will be apparent to those skilled in the art.

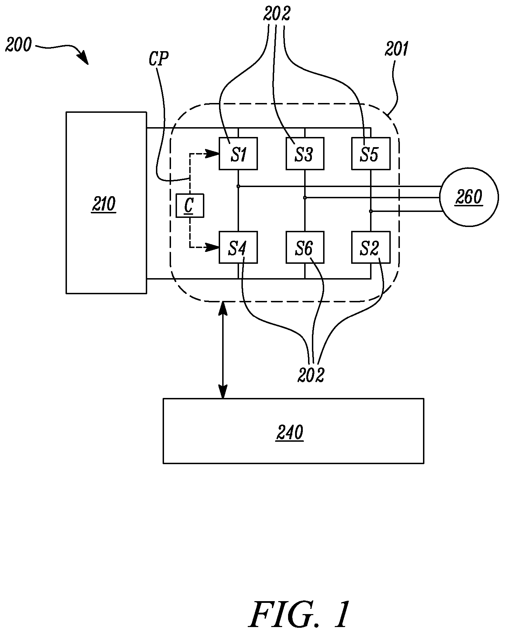

FIG. 1 shows a schematic block diagram of a power converter health monitoring system 200, according to an embodiment of the present disclosure.

The power converter health monitoring system 200 comprises a power converter 201. In the illustrated embodiment of FIG. 1, the power converter 201 is a three-phase inverter. However, in some other embodiments, the power converter 201 may be any power converter based on desired application attributes.

The power converter 201 is electrically connected to a DC voltage supply 210. The DC voltage supply 210 is configured to provide a DC power to the power converter 201. In some embodiments, the DC voltage supply 210 is a battery. In some embodiments, the DC voltage supply 210 may be a rectifier. Further, the power converter 201 is electrically connected to a load 260. In some embodiments, the load 260 may be a three-phase motor. In some embodiments, the load 260 may be a propulsion motor.

The power converter health monitoring system 200 further comprises a portable health monitoring unit 240. The portable health monitoring unit 240 is communicably connected to the power converter 201.

The power converter 201 comprises a plurality of power devices 202 and a controller C. In the illustrated embodiment of FIG. 1, the power converter 201 comprises six power devices S1, S2, S3, S4, S5, and S6. However, in some other embodiments, the power converter 201 may include any number of power devices 202 based on desired application attributes. The controller C is communicably connected to each of the plurality of power devices 202. The plurality of power devices 202 may include insulated-gate bipolar transistors (IGBT) devices, silicon carbide (SiC) devices, and Gallium nitride (GaN) devices.

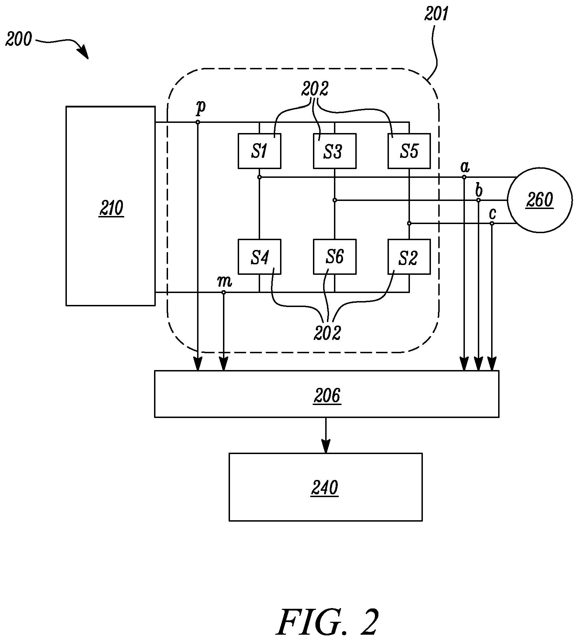

FIG. 2 shows a schematic block diagram of the power converter health monitoring system 200, according to an embodiment of the present disclosure. FIG. 2 further illustrates a plurality of voltage sensors 206 configured to measure electrical voltages across corresponding plurality of power devices 202. In some embodiments, each of the plurality of voltage sensors 206 may be a high band width voltage sensor.

In the illustrated example of FIG. 2, points p, m, a, b, and c are shown electrically connected to the plurality of voltage sensors 206. In order to measure a voltage across the power device S1, the point p and the point a may be electrically connected to a corresponding voltage sensor from the plurality of voltage sensors 206 and in order to measure a voltage across the power device S2, the point m and the point c may be electrically connected to a corresponding voltage sensor from the plurality of voltage sensors 206. Similarly, in order to measure a voltage across the power device S3, the point p and the point b may be electrically connected to a corresponding voltage sensor from the plurality of voltage sensors 206 and in order to measure a voltage across the power device S4, the point m and the point a may be electrically connected to a corresponding voltage sensor from the plurality of voltage sensors 206. Further, in order to measure a voltage across the power device S5, the point p and the point c may be electrically connected to a corresponding voltage sensor from the plurality of voltage sensors 206 and in order to measure a voltage across the power device S6, the point m and the point b may be electrically connected to a corresponding voltage sensor from the plurality of voltage sensors 206. In the illustrated example of FIG. 2, each of the plurality of voltage sensors 206 is communicably connected to the portable health monitoring unit 240.

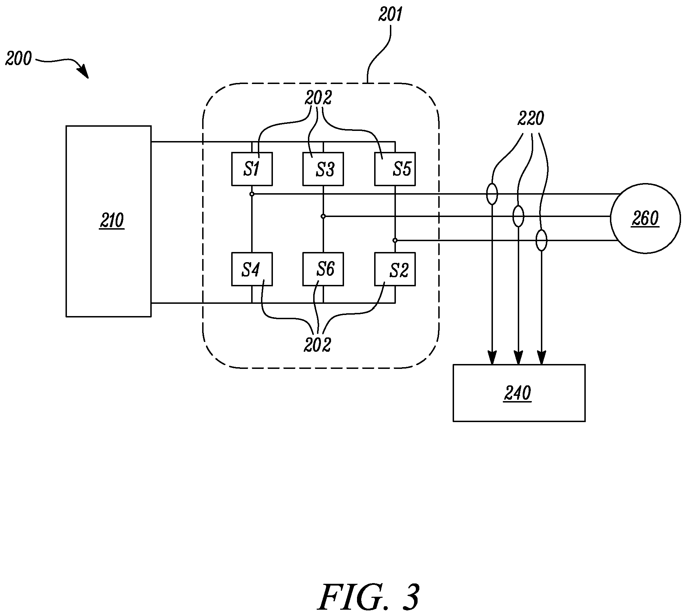

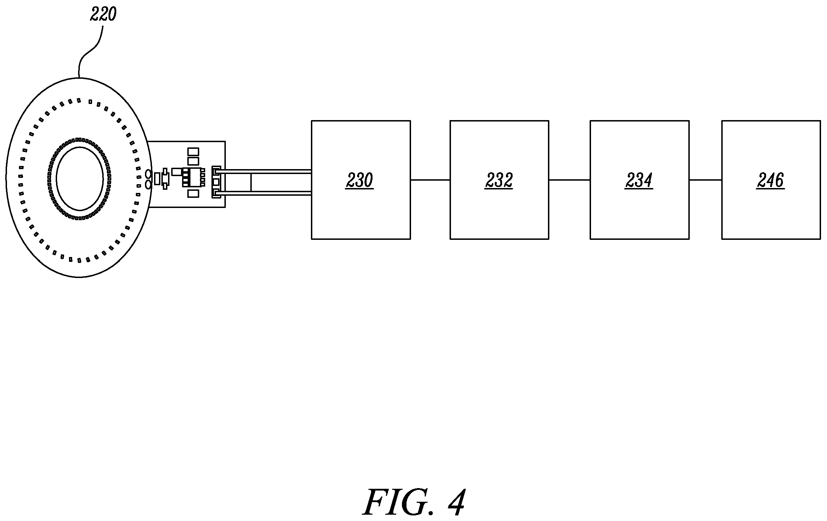

FIG. 3 shows a schematic block diagram of the power converter health monitoring system 200, according to an embodiment of the present disclosure. FIG. 3 further illustrates a plurality of current sensors 220 configured to measure electrical currents through corresponding plurality of power devices 202. FIG. 4 shows a schematic block diagram of a current sensor 220 from the plurality of current sensors 220, according to an embodiment of the disclosure.

Referring to FIGS. 3 and 4, the plurality of current sensors 220 may be clamped onto terminals of the load 260 for sensing currents through the power devices 202. After being clamped, the current sensors 220 may send sensed current signals to an integrator 230 configured to accumulate the current signals over time. Further, an amplifier 232 may amplify the current signals and a filter 234 may remove unnecessary high frequency noise or interference from the current signals.

In the illustrated embodiment of FIGS. 3 and 4, each of the plurality of current sensors 220 is a Rogowski coil. Such current sensors 220 may not require any high voltage isolation. Further, the plurality of current sensors 220 may have no physical or direct connection with the power converter health monitoring system 200.

In the illustrated embodiment of FIG. 3, each of the plurality of current sensors 220 is communicably connected to the portable health monitoring unit 240. The portable health monitoring unit 240 further comprises a processor 246. The processor 246 of the portable health monitoring unit 240 may further process the current signals received from the filter 234.

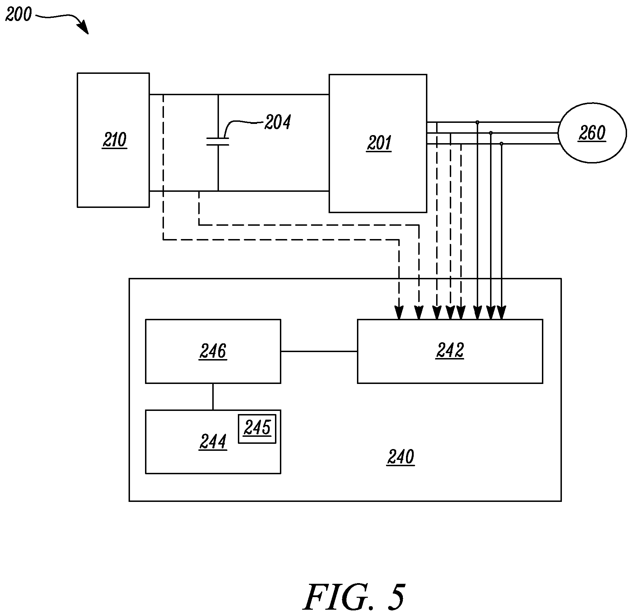

FIG. 5 shows a schematic block diagram of the power converter health monitoring system 200, according to an embodiment of the present disclosure. Specifically, the portable health monitoring unit 240 is shown in more detail in FIG. 5.

In some embodiments, the power converter health monitoring system 200 further comprises a capacitor 204 electrically connected in parallel with the plurality of power devices 202. In some embodiments, the capacitor 204 is a DC link capacitor. In some cases, the DC voltage supply 210 may introduce parasitic inductance in the power converter 201. For example, when the DC voltage supply 210 is the rectifier, the DC voltage supply 210 may introduce its own harmonics into the power converter 201. In such cases, the capacitor 204 may be used to eliminate the harmonics and provide a fundamental component to the power converter 201. Hence, the capacitor 204 may play an important role in the operation of the power converter 201.

In some embodiments, the portable health monitoring unit 240 comprises a circuit 242. The circuit 242 is configured to calculate various electrical parameters for the power converter 201 based on the measured electrical currents and voltages received from the plurality of current sensors 220 and the plurality of voltage sensors 206, respectively.

In some embodiments, the processor 246 is communicably coupled to the circuit 242. The processor 246 is configured to execute a plurality of instructions to perform operations described herein. The processor 246 may be further configured to generate an alert 245 when the power converter 201 is degraded.

In some embodiments, the portable health monitoring unit 240 further comprises a display 244 communicably coupled to the processor 246. The display 244 may be configured to display the alert 245 when the power converter 201 is degraded.

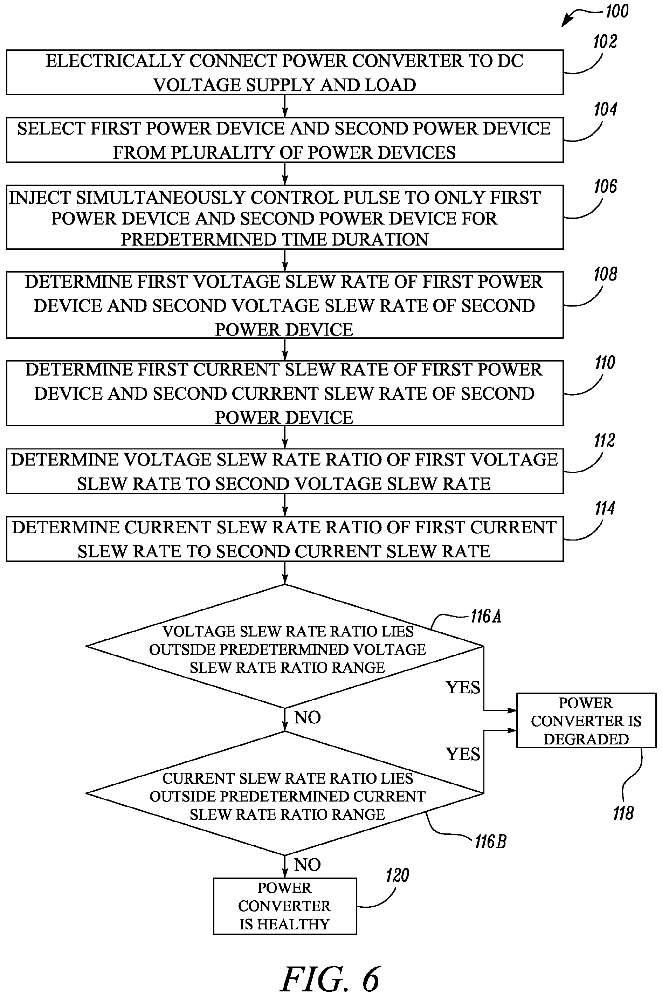

FIG. 6 shows a flow chart for a method 100 for monitoring the health of the power converter 201 having the plurality of power devices 202, according to an embodiment of the present disclosure. The method 100 will further be described with reference to FIGS. 1 to 6. In some embodiments, the processor 246 may perform the method 100 described herein. In some embodiments, the processor 246 may perform the method 100 when a trigger is provided by a user, such as a pilot or a maintenance person. The method 100 for monitoring the health of the power converter 201 is performed before a prestart check or during a service or an on-wing inspection/maintenance.

At step 102, the method 100 comprises electrically connecting the power converter 201 to the DC voltage supply 210 and the load 260.

At step 104, the method 100 comprises selecting a first power device and a second power device from the plurality of power devices 202. For example, the power device S1 may be selected as the first power device and the power device S4 may be selected as the second power device.

At step 106, the method 100 comprises injecting simultaneously a control pulse CP to only the first power device and the second power device for a predetermined time duration. In other words, the method 100 comprises injecting simultaneously the control pulse CP to only two selected power devices from the plurality of power devices 202. For example, the power devices S1 and the power device S4 may be injected simultaneously the control pulse CP for the predetermined time duration.

In some embodiments, the control pulse CP is simultaneously provided to only the first power device and the second power device by the controller C of the power converter 201. Furthermore, in some embodiments, the control pulse CP has a frequency range from 1 Hertz (Hz) to 1 Megahertz (MHz). In some embodiments, the predetermined time duration is based on a duty cycle of the control pulse CP. The control pulse CP is simultaneously provided to only the first power device and the second power device by the controller C of the power converter 201 before the pre-start check or during the service, or the on-wing inspection/maintenance.

At step 108, the method 100 comprises determining a first voltage slew rate of the first power device and a second voltage slew rate of the second power device. For example, the first voltage slew rate of the power device S1 and the second voltage slew rate of the power device S4 may be determined.

In some embodiments, the first voltage slew rate of the first power device and the second voltage slew rate of the second power device may be determined by using the portable health monitoring unit 240. In some embodiments, the first voltage slew rate of the first power device and the second voltage slew rate of the second power device may be determined by the processor 246 of the portable health monitoring unit 240.

In some embodiments, determining the first voltage slew rate of the first power device further comprises measuring a first voltage across the first power device using a first voltage sensor and determining the first voltage slew rate as a rate of change of the first voltage with respect to time. Similarly, in some embodiments, determining the second voltage slew rate of the second power device comprises measuring a second voltage across the second power device using a second voltage sensor and determining the second voltage slew rate as a rate of change of the second voltage with respect to time.

The first and second voltage sensors may be the voltage sensors from the plurality of voltage sensors 206 shown in FIG. 2. For example, for measuring the first voltage across the first power device, e.g., the power device S1, the first voltage sensor may be disposed between the points p, a. Similarly, for measuring the second voltage across the second power device, e.g., the power device S4, the second voltage sensor may be disposed between the points m, a.

At step 110, the method 100 comprises determining a first current slew rate of the first power device and a second current slew rate of the second power device. For example, the first current slew rate of the power device S1 and the second current slew rate of the power device S4 may be determined.

In some embodiments, the first current slew rate of the first power device and the second current slew rate of the second power device may be determined by using the portable health monitoring unit 240. In some embodiments, the first current slew rate of the first power device and the second current slew rate of the second power device may be determined by the processor 246 of the portable health monitoring unit 240.

In some embodiments, determining the first current slew rate of the first power device comprises measuring a first current through the first power device using a first current sensor and determining the first current slew rate as a rate of change of the first current with respect to time. In some embodiments, the first current sensor is a Rogowski coil.

In some embodiments, determining the second current slew rate of the second power device comprises measuring a second current through the second power device using a second current sensor and determining the second current slew rate as a rate of change of the second current with respect to time. In some embodiments, the second current sensor is a Rogowski coil.

The first and second current sensors may be the current sensors from the plurality of current sensors 220 shown in FIG. 3. For example, for measuring the first current through the first power device, e.g., the power device S1, the first current sensor may be electrically connected between the power device S1 and the load 260. Similarly, for measuring the second current through the second power device, e.g., the power device S4, the second current sensor may be electrically connected between the power device S4 and the load 260.

At step 112, the method 100 comprises determining a voltage slew rate ratio of the first voltage slew rate to the second voltage slew rate.

At step 114, the method 100 comprises determining a current slew rate ratio of the first current slew rate to the second current slew rate.

In some embodiments, the voltage slew rate ratio and the current slew rate ratio are determined by using the portable health monitoring unit 240. In some embodiments, the voltage slew rate ratio and the current slew rate ratio are determined by the processor 246 of the portable health monitoring unit 240.

At step 116A, the method 100 comprises determining if the voltage slew rate ratio lies outside a predetermined voltage slew rate ratio range. If the voltage slew rate ratio lies outside the predetermined voltage slew rate ratio range, the method 100 proceeds to step 118. Otherwise, the method 100 proceeds to step 116B.

At step 116B, the method 100 comprises determining if the current slew rate ratio lies outside a predetermined current slew rate ratio range. If the current slew rate ratio lies outside the predetermined current slew rate ratio range, the method 100 proceeds to step 118. Otherwise, the method 100 proceeds to step 120.

At step 118, the method 100 comprises determining that the power converter is degraded, i.e., if the voltage slew rate ratio lies outside the predetermined voltage slew rate ratio range and/or if the current slew rate ratio lies outside the predetermined current slew rate ratio range. In some embodiments, the method 100 further comprises providing the alert 245 (shown in FIG. 5) upon determining that the power converter 201 is degraded.

At step 120, the method 100 comprises determining that the power converter is healthy, i.e., if the voltage slew rate ratio lies within the predetermined voltage slew rate ratio range and the current slew rate ratio lies within the predetermined current slew rate ratio range.

In some embodiments, the portable health monitoring unit 240 is further used for determining if the power converter 201 is degraded. In some embodiments, the predetermined voltage slew rate ratio range and the predetermined current slew rate ratio range are based on historical data. The historical data may be stored in a memory (not shown) of the portable health monitoring unit 240. The memory may be communicably connected to the processor 246 of the portable health monitoring unit 240. It may be assumed that a 10% to 20% change from an initial value is a sign of a degradation or a failure.

The method 100 may not interfere with an operation of the power converter 201. Instead, the method 100 may be performed before the prestart check or during the service or the on-wing inspection/maintenance to monitor the health of the power converter 201, such as identifying early device aging and failure and thereby predicting component degradation. This may increase availability and improve reliability of the power converter 201.

The method 100 may further eliminate a need of an equipment health monitoring (EHM) unit on an aircraft, which may reduce a certification demand and a weight of the aircraft. The method 100 may allow maintenance to be scheduled in or other actions to be taken to prevent consequential damages of a power and propulsion system of the aircraft.

The method 100 may not require continuous voltage and current measurement with a high sampling rate. Further, the method 100 may use less amount of data with respect to other conventional condition monitoring approaches to monitor the health of the power converter 201, such as identifying early device aging and failure. Therefore, the method 100 may be easy to implement. Further, the method may not require a high-end processor. Instead, the method may be executed by a less complex processing unit (e.g., the processor 246) for monitoring the health of the power converter 201. Further, the method 100 may be applicable to any type of power converters 201 (e.g., low power converters and high-power converters) having any type of power devices 202.

### List of reference signs (part of the description)

- 100: Method
- 102: Step
- 104: Step
- 106: Step
- 108: Step
- 110: Step
- 112: Step
- 114: Step
- 116A & B: Step
- 118: Step
- 120: Step
- 200: Power Converter Health Monitoring System
- 201: Power Converter
- 202: Plurality of Power Devices
- 204: Capacitor
- 206: Plurality of Voltage Sensors
- 210: DC Voltage Supply
- 220: Plurality of Current Sensors
- 230: Integrator
- 232: Amplifier
- 234: Filter
- 240: Portable Health Monitoring Unit
- 242: Circuit
- 244: Display
- 245: Alert
- 246: Processor
- 260: Load
- a: Point
- b: Point
- c: Point
- m: Point
- p: Point
- S1: Power Device
- S2: Power Device
- S3: Power Device
- S4: Power Device
- S5: Power Device
- S6: Power Device
- C: Controller
- CP: Control Pulse

## Claims

1. A method (100) for monitoring a health of a power converter (201) having a plurality of power devices (202), the method (100) comprising the steps of:
electrically connecting the power converter (201) to a DC voltage supply (210) and a load (260);
selecting a first power device and a second power device from the plurality of power devices (202);
injecting simultaneously a control pulse (CP) to only the first power device and the second power device for a predetermined time duration;
determining a first voltage slew rate of the first power device and a second voltage slew rate of the second power device;
determining a first current slew rate of the first power device and a second current slew rate of the second power device;
determining a voltage slew rate ratio of the first voltage slew rate to the second voltage slew rate;
determining a current slew rate ratio of the first current slew rate to the second current slew rate; and
determining that the power converter (201) is degraded if at least one:
the voltage slew rate ratio lies outside a predetermined voltage slew rate ratio range; and
the current slew rate ratio lies outside a predetermined current slew rate ratio range.

2. The method (100) of claim 1, wherein determining the first voltage slew rate of the first power device further comprises:
measuring a first voltage across the first power device using a first voltage sensor; and
determining the first voltage slew rate as a rate of change of the first voltage with respect to time.

3. The method (100) of claim 1 or 2, wherein determining the second voltage slew rate of the second power device further comprises:
measuring a second voltage across the second power device using a second voltage sensor; and
determining the second voltage slew rate as a rate of change of the second voltage with respect to time.

4. The method (100) of any preceding claim, wherein determining the first current slew rate of the first power device further comprises:
measuring a first current through the first power device using a first current sensor; and
determining the first current slew rate as a rate of change of the first current with respect to time.

5. The method (100) of claim 4, wherein the first current sensor is a Rogowski coil.

6. The method (100) of any preceding claim, wherein determining the second current slew rate of the second power device further comprises:
measuring a second current through the second power device using a second current sensor; and
determining the second current slew rate as a rate of change of the second current with respect to time.

7. The method (100) of claim 6, wherein the second current sensor is a Rogowski coil.

8. The method (100) of any preceding claim, wherein the control pulse (CP) is simultaneously provided to only the first power device and the second power device by a controller (C) of the power converter (201).

9. The method (100) of any preceding claim, wherein the voltage slew rate ratio and the current slew rate ratio are determined by using a portable health monitoring unit (240).

10. The method (100) of claim 9, wherein the portable health monitoring unit (240) is further used for determining if the power converter (201) is degraded.

11. The method (100) of any preceding claim, wherein the control pulse (CP) has a frequency range from 1 Hertz (Hz) to 1 Megahertz (MHz).

12. The method (100) of any preceding claim, wherein the predetermined time duration is based on a duty cycle of the control pulse (CP).

13. The method (100) of any preceding claim, wherein the predetermined voltage slew rate ratio range and the predetermined current slew rate ratio range are based on historical data.

14. The method (100) of any preceding claim, further comprising providing an alert (245) upon determining that the power converter (201) is degraded.

15. The method (100) of any preceding claim, wherein the DC voltage supply (210) is a battery.
